# FASCICULE DE BREVET EUROPEEN

(11) **EP 3 605 626 B1**
(45) Date de publication et mention de la délivrance du brevet: **04.05.2022**
(21) Numéro de dépôt: 19189138.1
(22) Date de dépôt: 30.07.2019
(51) Int. Cl.: H01L 41/187, H01L 41/316, H01L 41/319

(54) **DISPOSITIF A BASE DE NIOBATE ALCALIN COMPRENANT UNE COUCHE BARRIERE ET PROCEDE DE FABRICATION**
VORRICHTUNG AUF BASIS VON ALKALI-NIOBAT, DIE EINE TRENNSCHICHT UMFASST, UND HERSTELLUNGSVERFAHREN
DEVICE MADE OF ALKALINE NIOBATE COMPRISING A BARRIER LAYER AND METHOD FOR MANUFACTURING SAME

(30) Priorité: 02.08.2018 FR 1857235
(43) Date de publication de la demande: 05.02.2020
(73) Titulaire: Commissariat à l'Energie Atomique et aux Energies Alternatives, 75015 Paris (FR)
(72) Inventeur: HALIMAOUI, Aomar, 38660 LA TERRASSE (FR); MOULIN, Cécile, 38054 GRENOBLE Cedex 09 (FR); RODRIGUEZ, Guillaume, 38054 GRENOBLE Cedex 09 (FR)
(74) Mandataire: Marks & Clerk France

(56) Documents cités:
- JP-A- 2017 038 082
- US-A1- 2007 024 162
- US-A1- 2016 284 969

## Description

Le domaine de l'invention est celui des matériaux piézoélectriques qui interviennent dans de nombreuses applications. Les applications les plus importantes sont notamment : les filtres RF, les actuateurs, les transducteurs (MEMS).

Les matériaux piézoélectriques utilisés industriellement sont typiquement :
- le PbZrTiO₃ (PZT) pour les actuateurs (et les transducteurs), cependant concernant l'avenir du PZT, les Régulations Européennes WEEE (Waste Electrical and Electronic Equipment) exigent l'élimination du Pb à moyen terme. Des mêmes régulations ont été adoptées par les USA, le Canada, le Japon, la Chine et la Corée. Il devient ainsi nécessaire de remplacer ce matériau par des matériaux sans plomb ou « Lead free ;
- l'AIN pour les filtres RF et les transducteurs. On cherche néanmoins à remplacer AIN par un matériau plus performant présentant un meilleur coefficient de couplage. Quelques coefficients de couplage sont mentionnés ci-après en comparaison avec l'AIN : Kₜ² = 7% (AIN), Kₜ² = 12% (AINSc), Kₜ² > 40% (LiNbO₃).

Concernant AlNSc (avec Sc compris entre 10 et 40%) : ce matériau de la famille de AlN ne devrait pas poser de problèmes de dépôt, néanmoins on rencontre des difficultés de fabrication de cibles utilisant l'élément Sc. Par ailleurs Sc est un élément peu abondant et donc cher.

D'autres matériaux prometteurs sont actuellement étudiés tels : KₓNa₁₋ₓNbO₃ (KNN) pour des applications d'actuateurs et LiNbO₃ (LNO) pour des applications de filtres RF.

Concernant KₓNa₁₋ₓNbO₃ (KNN) : ce matériau est difficile à déposer. Actuellement une seule compagnie Japonaise (SCIOCS), spécialisée dans la fourniture de substrats, propose des couches de KNN bien cristallisées déposées sur du Pt (100 mm wafers).

Concernant LiNbO₃ (LNO) : des développements sont déjà réalisés avec des substrats massifs de LNO (100 mm de diamètre) utilisés comme substrat donneur pour transférer, sur un substrat accepteur, des couches minces cristallines de LNO (procédé Smart Cut^{™}). Néanmoins ce matériau est difficile à déposer selon les procédés actuellement publiés.

Concernant les procédés de dépôt de matériau piézoélectrique, les plus connus sont notamment :
- des procédés de dépôts par ablation laser : « Pulsed Laser Déposition » (PLD), offrant des résultats très encourageants, malgré des équipements non encore matures ;
- des procédés de Pulvérisation Cathodique (Sputtering), pour lesquels, les équipements sont d'ores et déjà matures et largement utilisés en industrie. Des essais ont été réalisés pour déposer LNO, KNN et PZT, mais rencontrent encore des difficultés.

Concernant les dispositifs précités (Filtres, Actuateur, Transducteur de façon générale), tous utilisent des structures Métal Isolant Métal (MIM).

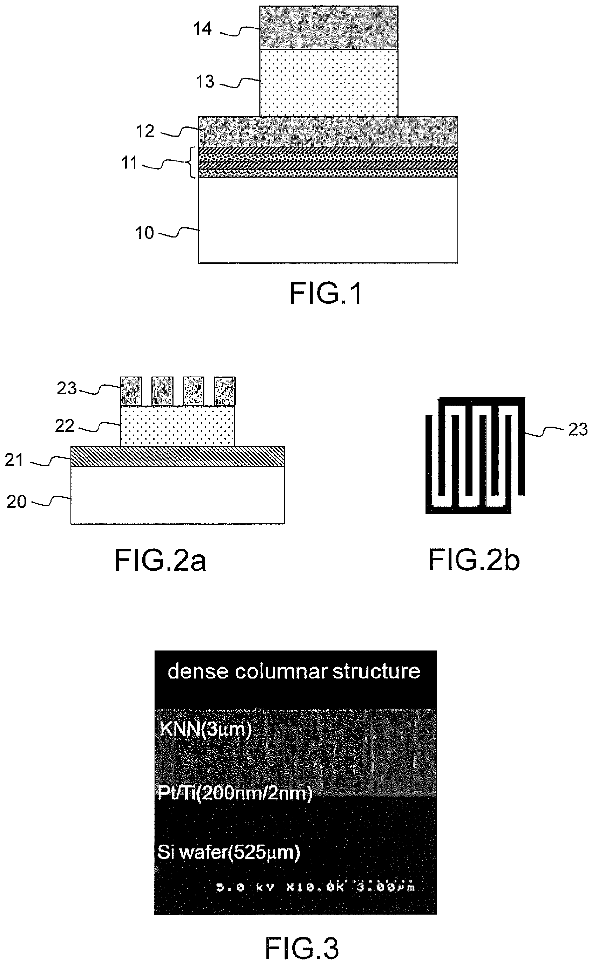

La figure 1 illustre un exemple de dispositif comprenant une telle structure. Plus précisément, sur un substrat 10, est réalisée : une structure de miroir de Bragg (réflecteur dans le cas de filtres RF) 11, une électrode inférieure **12,** une couche de matériau piézoélectrique **13** et une électrode supérieure **14,** permettant de réaliser un transducteur piézoélectrique.

Au niveau de la compatibilité métal/matériau piézoélectrique, il est notamment connu d'utiliser :
- du Pt avec les pérovskites (PZT, KNN) ;
- du Mo avec AlN, AlNSc (Wurtzite);
- du Pt ou Mo avec LNO.

Ces métaux sont les plus utilisés, même si d'autres métaux sont possibles, en particulier le Ti dans le cas de l'AlN...

Pour les filtres on peut également utiliser des dépôts sur isolant et n'utiliser que des électrodes surfaciques, afin par exemple de réaliser un dispositif à ondes élastiques de surface couramment dénommés (SAW), ces dispositifs étant néanmoins de moins en moins utilisés pour la réalisation de filtres RF car ils sont limités en puissance et en fréquence. Les figures 2a et 2b illustrent ce type de dispositif à ondes élastiques de surface. Sur un substrat **20,** on réalise une couche d'isolant **21,** une couche de matériau piézoélectrique **22** et des électrodes interdigitées **23.** La figure 2b illustre une vue de dessus des électrodes surfaciques **23.**

Un état de certains travaux réalisés par la société SCIOCS est résumé ci-après concernant les performances de dispositif piézoélectrique utilisant le dépôt de KNN par pulvérisation sur métal Pt et plus particulièrement un dispositif tel que celui illustré en figure 3 qui montre un wafer de Si de 525 µm d'épaisseur, une couche d'accroche en Ti de 2 nm, une couche conductrice en Pt de 200 nm sur laquelle a été réalisé un dépôt de KNN de 3 µm.

Le tableau ci-dessous est extrait de la référence : **https://www.sciocs.com/english/products/KNN.html**

| | for actuator | for sensor |
|---|---|---|
| materials | KNN = (K,Na)NbO₃ | |
| thickness | 1~5µm (typical 2~3µm) | |
| wafer diameter | 4inch, 6inch | |
| substrate | Si, SOI | |
| piezoelectric constant | d₃₁=100pm/V | d₃₁=80pm/V |
| dielectric constant | 900 | 350 |

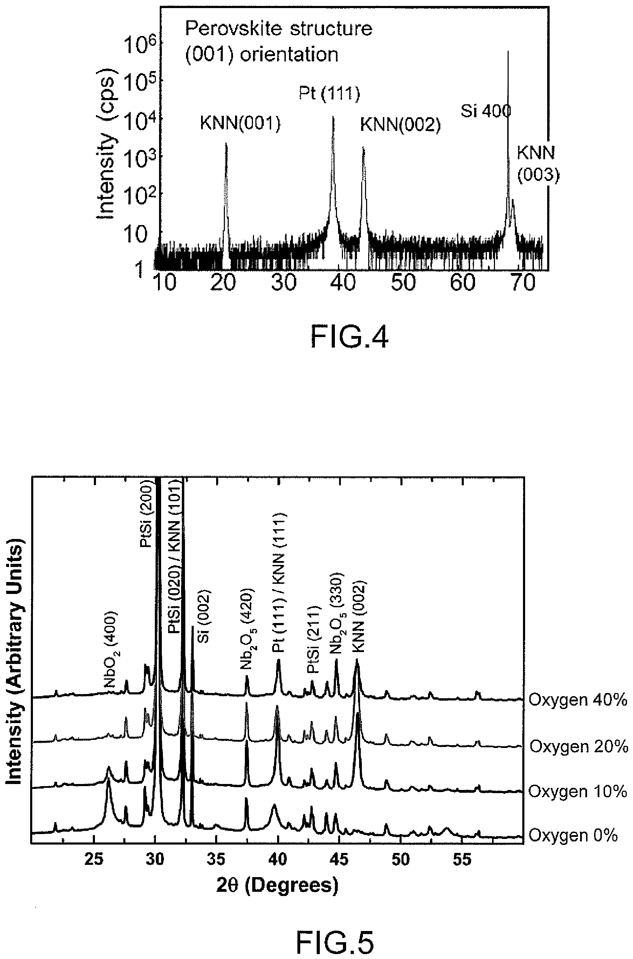

Les auteurs ont obtenus des résultats très satisfaisants en termes de phase cristalline, bien orientée, comme en témoigne la figure 4, avec des pics cristallographiques de bonne qualité. Néanmoins, les auteurs ne décrivent pas les procédés d'obtention de la couche de KNN et la figure 3 ne montre aucune couche intermédiaire à l'interface Pt/KNN.

Il est par ailleurs connu dans la littérature, la déficience en éléments alcalins d'une couche en matériau KNN. Notamment, la publication : « *Alkali ratio control for lead-free piezoelectric films utilizing elemental diffusivities in RF plasma* » de Hussein Nili, Ahmad Esmaielzadeh Kandjani, Johan Du Plessis, Vipul Bansal, Kourosh Kalantar-zadeh, Sharath Sriram and Madhu Bhaaskaran, fournit des résultats moins satisfaisants. La figure 5 extraite de cette publication met en évidence plusieurs orientations pour KNN et 3 phases, alors que l'on souhaite obtenir une orientation et une phase.

Dans ce contexte, le Demandeur a cherché à comprendre les phénomènes mis en jeu lors de la formation de la couche de matériau piézoélectrique.

Pour obtenir une qualité satisfaisante de la couche de matériau piézoélectrique en contact avec la couche métallique sur laquelle elle doit être déposée, il est nécessaire que la couche en métal, par exemple en Pt ou Mo soit de bonne qualité elle-même. A ce titre, on maîtrise la réalisation de couche de Pt (111) bien orientée, qu'on peut ainsi utiliser pour déposer du matériau piézoélectrique.

La qualité ainsi que l'orientation de la couche de matériau piézoélectrique sur toute son épaisseur dépendent du dépôt des premières couches déposées par pulvérisation.

Il est donc nécessaire de maitriser la composition des premières couches mais l'état de l'art décrit dans certaines publications met en évidence des dépôts sous stœchiométriques (manque du Na et K surtout à l'interface) et concernant des dépôts de KNN par plasma RF.

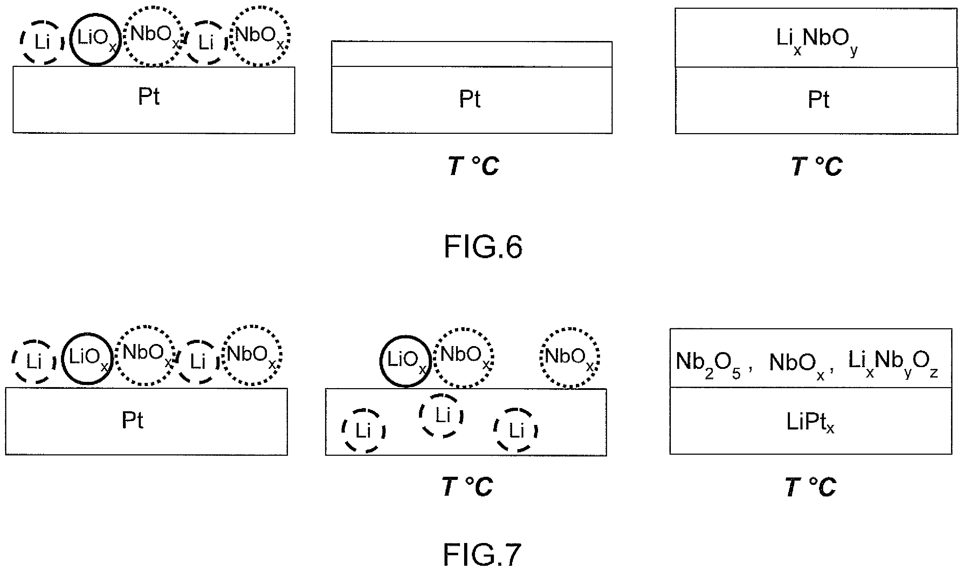

La représentation schématique de la figure 6 met en évidence les éléments présents : Li, LiOₓ, NbOₓ, à la surface de la couche de Pt après pulvérisation, en vue de la formation d'une couche de LiₓNbO_{y}. Il conviendrait donc de contrôler la stoechiométrie de la couche et d'ajuster les conditions de dépôts (flux de O₂, Ar, Pression...) et la composition de la cible, pour obtenir du LiNbO₃ stœchiométrique.

La réalité est plus complexe et différentes espèces se forment comme l'illustre la représentation schématique de la figure 7.

Dès les premières couches déposées, le Li diffuse et réagit avec le Pt, créant ainsi une déficience en Li dans les premières couches déposées. Cette déficience en Li conduit à la formation d'autres phases. Par ailleurs, la réaction du Pt avec Li conduit à la formation d'un composé Pt-Li qui change la configuration de la surface sur laquelle se fait la suite du dépôt. La réactivité du Li avec le Pt est tout à fait vraisemblable. En effet, les auteurs J.Sangster et A.D. Pelton de l'Ecole Polytechnique de Montréal dans « *The Li-Pt (Lithium-Platinum) System* », Journal of Phase Equilibria Vol.12, pages 678-681, 1991, ont décrit la formation d'eutectics PtLiₓ dès 290°C.

Le même comportement a été décrit avec les autres alcalins (Na, K) et les métaux nobles : « Reactions between Some Alkali and Platinum Groups Metals » de O.Loebich, Jr. and Ch.J. Raub, Forschungsinstitut für Edelmetalle und Metallchemie, Schwäbisch Gmünd, West Germany, dans Platinum Metals Rev. 25, (3), 113-120. La diffusion des alcalins dans les métaux a également été décrite comme très rapide dès 100°C, dans « Diffusion of Alkali Metals In Molybdenum and Nobium » M.G. Karpman, G.V. Scherbedinskii, G.N. Dubinin, and G.P. Benediktova, dans Metal Science and Heat Treatment 9, 202-204 (1967).

Pour empêcher la diffusion et la réaction des alcalins (Li, Na, K) avec l'électrode inférieure, le Demandeur propose d'intégrer une couche barrière à la surface de l'électrode inférieure. Pour être efficace, cette barrière doit être inerte (non réactive) vis-à-vis des alcalins et du métal de l'électrode inférieure (Pt, Mo...). Cette barrière doit aussi être capable d'empêcher la diffusion des alcalins vers l'électrode inférieure. Une telle couche barrière en matériau diélectrique, par exemple en SrTiO₃, est connue du document US 2007/024162 A1.

Plus précisément, la présente invention a pour objet un dispositif piézoélectrique comprenant au moins une couche supérieure de matériau piézoélectrique à base de niobate alcalin, une couche inférieure de métal située au dessus d'un substrat, et une couche barrière de matériau barrière à la diffusion d'alcalins dans ledit métal et inerte aux alcalins dudit niobate, ladite couche de matériau barrière étant située entre la couche inférieure de métal et la couche supérieure de matériau piézoélectrique, selon la revendication indépendante 1.

Le matériau piézoélectrique peut être notamment KNN ou LNO.

Selon des variantes de l'invention, le métal est du Pt ou tout autre métal comme du Mo ou du Ti.

Selon l'invention, ledit matériau barrière à la diffusion est un oxyde conducteur ou un nitrure conducteur, par exemple l'oxyde pouvant comprendre un métal Pt ou Ru ou Ir et de préférence du RuO₂.

Selon des variantes de l'invention, ledit matériau barrière à la diffusion est un nitrure pouvant être TiN ou WN ou TaN et de préférence du TiN.

En dehors de l'invention, le matériau barrière est un matériau isolant ou semiconducteur pouvant être un matériau piézoélectrique.

Selon des variantes de l'invention, l'épaisseur de la couche barrière est supérieure à plusieurs dizaines de nanomètres et de préférence de l'ordre d'une centaine de nanomètres.

Selon des variantes de l'invention, le dispositif comprend entre la surface du substrat et ladite couche inférieure de métal, lorsque ce métal est noble, une couche d'accroche dudit métal noble, la couche d'accroche pouvant être en TiO₂.

Selon des variantes de l'invention, l'épaisseur de la couche inférieure de métal pouvant être un métal noble étant supérieure à plusieurs dizaines de nanomètres, l'épaisseur de la couche d'accroche est de l'ordre de quelques nanomètres.

Selon des variantes de l'invention, le dispositif comprend une couche supérieure conductrice au dessus de la couche de matériau piézoélectrique.

L'invention a aussi pour objet un procédé de fabrication d'un dispositif selon l'invention, comprenant les étapes suivantes :
- le dépôt d'une couche inférieure de métal qui peut être un métal noble sur un substrat ;
- la réalisation d'une couche barrière à la surface de ladite couche inférieure de métal ;
- le dépôt d'une couche d'un matériau piézoélectrique à la surface de ladite couche barrière par pulvérisation cathodique à partir d'une cible.

Selon des variantes de l'invention, la pulvérisation cathodique est réalisée à une température supérieure à 300°C, de préférence à 500°C.

Selon des variantes de l'invention, le procédé comprend au moins une étape de pulvérisation réalisée à une pression de quelques dixièmes de Pa (mTorr) pour déposer le matériau piézoélectrique.

Selon des variantes de l'invention, le procédé comprend une première étape de pulvérisation réalisée à une première puissance RF, et une seconde étape de pulvérisation réalisée avec une seconde puissance RF plus élevée que la première puissance, pour déposer le matériau piézoélectrique.

Selon des variantes de l'invention, la première puissance RF est de l'ordre de 200W, la seconde puissance RF étant de l'ordre de 500W.

Selon des variantes de l'invention, le procédé comprend le dépôt d'une couche d'accroche à la surface du substrat, préalablement au dépôt de la couche inférieure de métal.

Selon des variantes de l'invention, le procédé comprend la réalisation d'un dépôt de couche supérieure de métal.

L'invention sera mieux comprise et d'autres avantages apparaitront à la lecture de la description qui va suivre donnée à titre non limitatif et grâce aux figures parmi lesquelles :
- la figure 1 schématise un dispositif de type transducteur selon l'art connu ;
- les figures 2a et 2b schématisent un dispositif à ondes élastiques de surface selon l'art connu ;
- la figure 3 illustre une photographie d'un empilement de KNN à la surface d'une couche de Pt selon l'art connu ;
- la figure 4 illustre les pics cristallographiques d'une couche de KNN sur une couche de Pt (111) selon l'art connu ;
- la figure 5 illustre les pics cristallographiques d'une couche de KNN déposée sur un métal Pt montrant différentes orientations cristallines de KNN et différentes phases, selon l'art connu ;
- la figure 6 schématise la formation d'une couche de LiₓNbO_{y} à partir de la pulvérisation d'une cible ;
- la figure 7 schématise la diffusion d'alcalins dans la couche de métal et la formation de différentes phases autres que LiₓNbO_{y} ;
- la figure 8 illustre un premier exemple de dispositif selon l'invention comprenant une couche barrière selon l'invention ;
- la figure 9 illustre un deuxième exemple de dispositif selon l'invention ;
- la figure 10 illustre un exemple de dispositif MIM selon l'invention.

De manière générale, le dispositif de l'invention comprend à la surface d'un substrat une couche conductrice de métal, sur laquelle on cherche à déposer une couche de matériau piézoélectrique alcalin de bonne qualité, par l'intermédiaire d'une couche barrière.

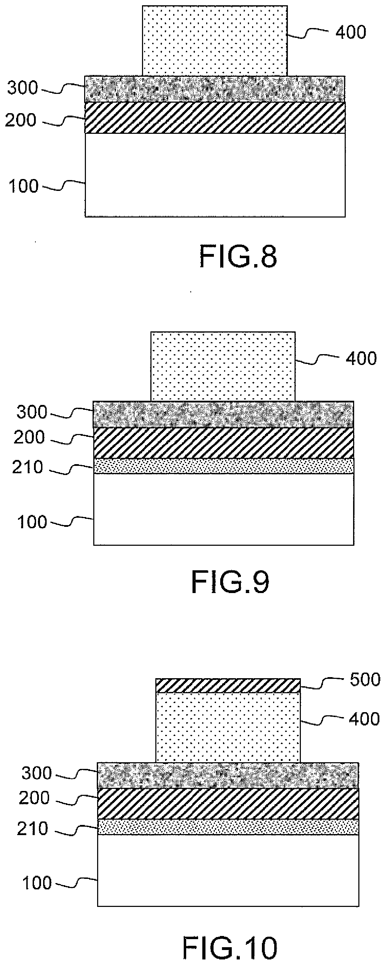

La figure 8 décrit un premier exemple de dispositif de l'invention, montrant un substrat **100,** une couche de métal noble **200,** une couche barrière **300,** une couche de matériau piézoélectrique **400.**

L'empilement, décrit en détail ci-dessous, est déposé sur un substrat adapté à l'application visée et qui peut être un substrat de saphir, de MgO, de verre ou encore de silicium ou de préférence un substrat de Si recouvert d'une couche isolante (de préférence une couche de SiO₂).

Avant le dépôt du matériau piézoélectrique, on procède d'abord au dépôt de l'électrode métallique inférieure (soit la couche **200)** suivi du dépôt de la couche barrière **300.** Pour constituer l'électrode inférieure d'un des dispositifs précités, on peut utiliser de préférence du Pt ou du Mo.

Pour le matériau barrière de la couche barrière, il est possible d'utiliser tout matériau dont le rôle est :
- d'empêcher les alcalins (Li, Na, K) de réagir avec l'électrode inférieure et ;
- d'empêcher ces mêmes alcalins de diffuser vers l'électrode inférieure.

Ces matériaux de barrière devant être inertes chimiquement vis-à-vis des alcalins, on utilise de préférence des oxydes ou des nitrures.

Dans le domaine des oxydes et des nitrures conducteurs, on peut utiliser des oxydes de métaux nobles (Pt, Ru, Ir) et de préférence du RuO₂.

Dans le domaine des nitrures il est possible d'utiliser de TiN, du WN, du TaN et de préférence du TiN.

En dehors de la portée d'invention, l'utilisation d'une barrière isolante est aussi possible comme décrit ci-dessus. Mais pour ne pas dégrader la réponse du matériau piézoélectrique, il est préférable d'utiliser une barrière qui est aussi piézoélectrique, comme le nitrure d'aluminium (AIN), par exemple.

Il peut être avantageux de prévoir une couche d'accroche favorisant l'accroche de la couche de métal sur le substrat.

La figure 9 illustre à cet effet, un second exemple de dispositif de l'invention comprenant sur un substrat **100** :
- une couche d'accroche **210** ;
- une couche de métal **200** ;
- une couche barrière de matériau barrière **300** ;
- une couche de matériau piézoélectrique **400.**

La figure 10 illustre le même empilement que celui décrit précédemment et représenté en figure 9, complété d'une électrode supérieure permettant d'élaborer un dispositif de type MIM, soit l'empilement suivant :
- un substrat **100** ;
- une couche d'accroche **210** ;
- une couche de métal **200** ;
- une couche barrière de matériau barrière **300** ;
- une couche de matériau piézoélectrique **400** ;
- une électrode supérieure **500.**

Pour réaliser le dispositif précité et illustré en figure 9, les étapes d'un procédé standard sont les suivantes :

### Etape 1 :

Pour améliorer l'adhésion de cette couche de Pt sur le substrat, on dépose préalablement une couche d'accroche en TiO₂, par exemple, de quelques nm d'épaisseur (5 nm).

### Etape 2 :

On procède au dépôt d'une électrode en Pt d'une épaisseur de quelques dizaines de nm, par exemple 100 nm, à la surface de ladite couche d'accroche.

### Etape 3 :

Sur la couche de Pt on procède au dépôt de la couche barrière en matériau barrière pouvant être RuO₂. Pour être efficace contre la diffusion des alcalins, l'épaisseur de cette couche barrière doit être d'au moins 80 nm (de préférence 100 nm) pour une température de dépôt du matériau piézoélectrique comprise entre 500 et 700°C.

### Etape 4 :

Le matériau piézoélectrique (LiNbO₃ ou KₓNa₁₋ₓNbO₃) est déposé par pulvérisation cathodique en utilisant une cible correspondant au matériau à déposer. Le dépôt est fait à une température supérieure à 300°C, de préférence à 500°C. Pour la pulvérisation, on utilise un mélange Ar:O₂ à une pression de quelques dixièmes de Pa (mTorr) et de préférence 0.67 Pa (5 mTorr). Le ratio Ar:O₂ peut être ajusté afin obtenir la vitesse de dépôt souhaité toute en limitant la quantité de lacunes d'oxygène dans le matériau piézoélectrique. Ce ratio Ar:O₂ est de préférence autour de 4 :1.

Pour la machine de pulvérisation utilisée notamment dans le cadre de plaque de Si de 200 mm, la puissance RF est de quelques centaines de Watt, typiquement 500 W.

Une autre variante consiste à déposer le matériau piézoélectrique par pulvérisation en utilisant deux puissances RF. Il est intéressant de commencer le dépôt des premières couches à une puissance RF plus faible (200 W, par exemple), puis d'augmenter la puissance RF à 500 W au bout 15 minutes.

## Revendications

1. Dispositif piézoélectrique comprenant au moins une couche supérieure **(400)** de matériau piézoélectrique à base de niobate alcalin,
une couche inférieure **(200)** de métal située au dessus d'un substrat **(100)**, et
une couche barrière **(300)** de matériau barrière à la diffusion d'alcalins dans ledit métal et inerte aux alcalins dudit niobate, ladite couche de matériau barrière étant située entre la couche inférieure de métal et la couche supérieure de matériau piézoélectrique, **caractérisé en ce que** est ledit matériau barrière à la diffusion est un oxyde conducteur ou un nitrure conducteur.

2. Dispositif selon la revendication 1, dans lequel le métal est du Pt ou du Mo ou du Ti.

3. Dispositif selon la revendication 1 ou 2, dans lequel l'oxyde comprend un métal Pt ou Ru ou Ir et de préférence du RuO₂.

4. Dispositif selon la revendication 1 ou 2, dans lequel ledit matériau barrière à la diffusion est un nitrure pouvant être TiN ou WN, ou TaN et de préférence TiN.

5. Dispositif selon l'une des revendications 1 à 4, dans lequel l'épaisseur de la couche barrière est supérieure à plusieurs dizaines de nanomètres et de préférence de l'ordre d'une centaine de nanomètres.

6. Dispositif selon l'une des revendications 1 à 5, comprenant, entre la surface du substrat et ladite couche inférieure de métal, lorsque ce métal est noble, une couche d'accroche dudit métal noble **(210),** par exemple en TiO₂.

7. Dispositif selon la revendications 6, dans lequel l'épaisseur de la couche inférieure de métal pouvant être un métal noble étant supérieure à plusieurs dizaines de nanomètres, l'épaisseur de la couche d'accroche est de l'ordre de quelques nanomètres.

8. Dispositif selon l'une des revendications 1 à 7, comprenant une couche supérieure conductrice **(500)** au dessus de la couche de matériau piézoélectrique.

9. Procédé de fabrication d'un dispositif selon l'une des revendications 1 à 8, comprenant les étapes suivantes :
- le dépôt d'une couche inférieure de métal qui peut être un métal noble sur un substrat ;
- la réalisation d'une couche barrière à la surface de ladite couche inférieure de métal ;
- le dépôt d'une couche d'un matériau piézoélectrique à la surface de ladite couche barrière par pulvérisation cathodique à partir d'une cible.

10. Procédé de fabrication selon la revendication 9, dans lequel la pulvérisation cathodique est réalisée à une température supérieure à 300°C, de préférence à 500°C.

11. Procédé de fabrication selon l'une des revendications 9 ou 10, comprenant au moins une étape de pulvérisation réalisée à une pression de quelques dixièmes de Pa (mTorr) pour déposer le matériau piézoélectrique.

12. Procédé de fabrication selon la revendication 11, comprenant une première étape de pulvérisation réalisée à une première puissance RF, et une seconde étape de pulvérisation réalisée avec une seconde puissance RF plus élevée que la première puissance, pour déposer le matériau piézoélectrique.

13. Procédé de fabrication selon l'une des revendications 9 à 12, comprenant le dépôt d'une couche d'accroche à la surface du substrat, préalablement au dépôt de la couche inférieure de métal.

14. Procédé de fabrication selon l'une des revendications 9 à 13, comprenant la réalisation d'un dépôt de couche supérieure de métal.

## Patentansprüche

1. Piezoelektrische Vorrichtung, umfassend mindestens eine obere Schicht (400) aus piezoelektrischem Material auf der Grundlage von Alkali-Niobat,
eine untere Schicht (200) aus Metall, welche oberhalb eines Substrates (100) angeordnet ist, und
eine Barriereschicht (300) aus einem Material, das eine Barriere für die Diffusion von Alkalimetallen in das Metall darstellt und das gegenüber den Alkalimetallen des Niobats inert istwobei die Schicht aus Barrierematerial zwischen der unteren Schicht aus Metall und der oberen Schicht aus piezoelektrischem Material angeordnet ist, **dadurch gekennzeichnet, dass** das Barrierematerial gegenüber der Diffusion ein leitfähiges Oxid oder ein leitfähiges Nitrid ist.

2. Vorrichtung nach Anspruch 1, wobei das Metall Pt oder Mo oder Ti ist.

3. Vorrichtung nach Anspruch 1 oder 2, wobei das Oxid ein Pt oder Ru oder Ir Metall und vorzugsweise RuO₂ umfasst.

4. Vorrichtung nach Anspruch 1 oder 2, wobei das Barrierematerial gegenüber Diffusion ein Nitrid ist, welches TiN oder WN oder TaN und vorzugsweise TiN sein kann.

5. Vorrichtung nach einem der Ansprüche 1 bis 4, wobei die Dicke der Barriereschicht größer als mehrere Zehn Nanometer ist und vorzugsweise ungefähr einhundert Nanometer beträgt.

6. Vorrichtung nach einem der Ansprüche 1 bis 5, umfassend, zwischen der Oberfläche des Substrates und der unteren Schicht aus Metall, wenn dieses Metall ein Edelmetall ist, eine Haftschicht aus dem Edelmetall (210), beispielsweise aus TiO₂.

7. Vorrichtung nach Anspruch 6, wobei die Dicke der unteren Schicht aus Metall, welche ein Edelmetall sein kann, größer als mehrere Zehn Nanometer ist, wobei die Dicke der Haftschicht ungefähr einige Nanometer misst.

8. Vorrichtung nach einem der Ansprüche 1 bis 7, umfassend eine obere leitfähige Schicht (500) oberhalb der Schicht aus piezoelektrischem Material.

9. Verfahren zum Herstellen einer Vorrichtung nach einem der Ansprüche 1 bis 8, folgende Schritte umfassend:
- die Ablagerung einer unteren Schicht aus Metall, welches ein Edelmetall sein kann, auf einem Substrat;
- die Schaffung einer Barriereschicht an der Oberfläche der unteren Metallschicht;
- die Ablagerung einer Schicht aus einem piezoelektrischen Material an der Oberfläche der Barriereschicht durch Kathodenzerstäubung von einem Ziel aus.

10. Herstellungsverfahren nach Anspruch 9, wobei die Kathodenzerstäubung bei einer Temperatur über 300 °C vorgenommen wird, vorzugsweise bei 500 °C.

11. Herstellungsverfahren nach einem der Ansprüche 9 oder 10, umfassend mindestens einen Schritt der Zerstäubung, welcher bei einem Druck von einigen Zehnteln Pa (mTorr) zur Ablagerung des piezoelektrischen Materials vorgenommen wird.

12. Herstellungsverfahren nach Anspruch 11, umfassend einen ersten Schritt der Zerstäubung, welcher bei einer ersten HF-Leistung durchgeführt wird und einen zweiten Schritt der Zerstäubung, welcher bei einer zweiten HF-Leistung durchgeführt wird, welche höher als die erste Leistung ist, um das piezoelektrische Material abzulagern.

13. Herstellungsverfahren nach einem der Ansprüche 9 bis 12, umfassend die Ablagerung einer Haftschicht an der Oberfläche des Substrates vor der Ablagerung der unteren Metallschicht.

14. Herstellungsverfahren nach einem der Ansprüche 9 bis 13, umfassend die Schaffung einer Ablagerung einer oberen Metallschicht.

## Claims

1. Piezoelectric device comprising at least one upper layer (400) of piezoelectric material, based on alkali metal niobate,
one lower layer (200) of metal located above a substrate (100), and
a barrier layer (300) of material that is a barrier to the diffusion of alkali metals into said metal and that is inert to the alkali metals of said niobate,
said barrier material layer being located between the lower layer of metal and the upper layer of piezoelectric material, **characterised in that** said diffusion barrier material is a conductive oxide or a conductive nitride.

2. Device according to claim 1, wherein the metal is Pt or Mo or Ti.

3. Device according to claim 1 or 2, wherein the oxide comprises a Pt or Ru or Ir metal and preferably RuO₂.

4. Device according to claim 1 or 2, wherein said diffusion barrier material is a nitride that may be TiN or WN or TaN and preferably TiN.

5. Device according to one of claims 1 to 4, wherein the thickness of the barrier layer is greater than several tens of nanometres and preferably of the order of around a hundred nanometres.

6. Device according to one of claims 1 to 5, comprising, between the surface of the substrate and said lower layer of metal, when this metal is a noble metal, an adhesion layer of said noble metal (210), for example made of TiO₂.

7. Device according to claim 6, wherein the thickness of the lower layer of metal, which may be a noble metal, being greater than several tens of nanometres, the thickness of the adhesion layer is of the order of a few nanometres.

8. Device according to one of claims 1 to 7, comprising a conductive upper layer (500) above the layer of piezoelectric material.

9. Method for manufacturing a device according to one of claims 1 to 8, comprising the following steps:
- depositing a lower layer of metal, which may be a noble metal, on a substrate;
- producing a barrier layer on the surface of said lower layer of metal;
- depositing a layer of a piezoelectric material on the surface of said barrier layer by cathode sputtering from a target.

10. Manufacturing method according to claim 9, wherein the cathode sputtering is carried out at a temperature above 300 °C, preferably at 500 °C.

11. Manufacturing method according one of claims 9 or 10, comprising at least one sputtering step carried out at a pressure of a few tens of Pascal (mTorr) in order to deposit the piezoelectric material.

12. Manufacturing method according to claim 11, comprising a first sputtering step carried out at a first RF power, and a second sputtering step carried out with a second RF power higher than the first power, in order to deposit the piezoelectric material.

13. Manufacturing method according to one of claims 9 to 12, comprising the deposition of an adhesion layer on the surface of the substrate, prior to the deposition of the lower layer of metal.

14. Manufacturing method according to one of claims 9 to 13, comprising carrying out a deposition of an upper layer of metal.
